# EUROPEAN PATENT APPLICATION

(11) **EP 2 405 467 A1**
(43) Date of publication of application: **11.01.2012**
(21) Application number: 09841075.6
(22) Date of filing: 02.03.2009
(51) Int. Cl.: H01L 21/338, H01L 29/778, H01L 29/812

(54) **NITRIDE SEMICONDUCTOR DEVICE AND METHOD FOR MANUFACTURING THE SAME**

(71) Applicant: Toyota Jidosha Kabushiki Kaisha, Toyota-shi, Aichi 471-8571 (JP)
(72) Inventor: SUGIMOTO, Masahiro, Toyota-shi Aichi 471-8571 (JP); SOEJIMA, Narumasa, Aichi-gun Aichi 480-1192 (JP); UESUGI, Tsutomu, Aichi-gun Aichi 480-1192 (JP); KODAMA, Masahito, Aichi-gun Aichi 480-1192 (JP); ISHII, Eiko, Aichi-gun Aichi 480-1192 (JP)
(74) Representative: Intès, Didier Gérard André
(86) International application number: PCT/JP2009/053834
(87) International publication number: WO 2010/100709

(57) **Abstract**

Provided are a vertical nitride semiconductor device in which occurrence of leak currents can be suppressed, and a method for manufacturing such nitride semiconductor device. A nitride semiconductor device (100), which is a vertical HEMT, is provided with an n⁻ type GaN first nitride semiconductor layer (2), p⁺ type GaN second nitride semiconductor layers (6a, 6b), an n⁻ type GaN third nitride semiconductor layer (9), and an n⁻ type AIGaN fourth nitride semiconductor layer (8) that is in hetero junction with a front surface of the third nitride semiconductor layer (9). Openings (11a, 11b) that penetrate the third nitride semiconductor layer (9) and reach front surfaces of the second nitride semiconductor layers (6a, 6b) are provided at positions isolated from the peripheral edge of the third nitride semiconductor layer (9). Source electrodes (12a, 12b) are provided in the openings (11a, 11b). Etching damage (7b) that is in contact with the source electrodes (12a, 12b) is surrounded by a region where no etching damage is formed.

## Description

### TECHNICAL FIELD

The present invention relates to a nitride semiconductor device and a method of manufacturing the same. Specifically, the present invention relates to a vertical nitride semiconductor device and a method of manufacturing the same.

### BACKGROUND ART

Vertical nitride semiconductor devices are being developed. This type of vertical nitride semiconductor devices is provided with an n-type nitride semiconductor layer and a p-type nitride semiconductor layer stacked on the front surface of the n-type nitride semiconductor layer. A groove is formed in the p-type layer, so as to penetrate the p-type layer. The n-type layer extends within that groove. An n-channel type current path extending in the vertical direction is secured by the n-type layer that extends in the groove of the p-type layer. A vertical semiconductor device (a semiconductor device in which a pair of electrodes is distributedly provided on a front surface and a back surface of a semiconductor substrate) is thus realized.

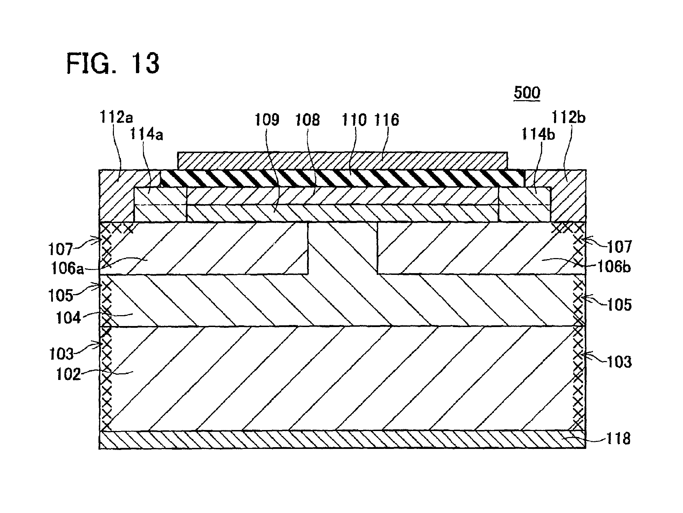

A patent literature 1 discloses a vertical nitride semiconductor device 500 and a manufacturing method thereof. Fig. 13 is a cross-sectional diagram of that nitride semiconductor device 500. The nitride semiconductor device 500 is an n-channel type vertical nitride semiconductor device having a HEMT (High Electron Mobility Transistor) structure. Specifically, a drain electrode 118 is formed on a back surface, and a pair of source electrodes 112a, 112b is formed on the front surface, such that a current flows in the vertical direction. The nitride semiconductor device 500 comprises a nitride semiconductor substrate 102 formed of n⁺ type GaN. A first nitride semiconductor layer 104 formed of n⁻ type GaN is provided on the front surface of the nitride semiconductor substrate 102. A pair of second nitride semiconductor layers 106a, 106b formed of p⁺ type GaN is provided at parts of the front surface of the first nitride semiconductor payer 104. A third nitride semiconductor layer 109 formed of n⁻ type GaN is provided on the front surface of the first nitride semiconductor layer 104 and on the front surfaces of the second nitride semiconductor layers 106a, 106b. A fourth nitride semiconductor layer 108 formed of n⁻ type AlGaN is provided in hetero junction with the front surface of the third nitride semiconductor layer 109. A gate electrode 116 is formed above the fourth nitride semiconductor layer 108. A pair of source electrodes 112a, 112b is provided on respective front surfaces of the second nitride semiconductor layers 106a, 106b, which are the termination portion of the nitride semiconductor device 500. In the nitride semiconductor device 500, when a positive voltage is applied to the gate electrode 116, a two-dimensional electron gas (hereafter notated as 2DEG) forms at the hetero junction surface between the third nitride semiconductor layer 109 and the fourth nitride semiconductor layer 108. As a result, the nitride semiconductor device 100 is turned on. The nitride semiconductor device 500 causes electrons to move by using the 2DEG.
Patent Literature 1: Japanese Patent Application Publication No. 2008-263412A

### SUMMARY OF THE INVENTION

### TECHNICAL PROBLEM

Nitride compounds such as GaN and the like are chemically stable materials, and are therefore difficult to etch by wet etching. Therefore, a dry etching such as RIE (Reactive Ion Etching) or the like is used to etch GaN. In dry etching, the surface of GaN is exposed to plasma of an etching gas, and N desorbs out of the GaN surface that is exposed to the plasma. In the manufacturing method of the nitride semiconductor device 500 of the patent literature 1, the third nitride semiconductor layer 109 and the fourth nitride semiconductor layer 108 are formed on the front surfaces of the second nitride semiconductor layers 106a, 106b, then the third nitride semiconductor layer 109 and the fourth nitride semiconductor layer 108 are removed, by dry etching, at the areas where the pair of source electrodes 112a, 112b is to be formed. At this time, the side faces of the nitride semiconductor substrate 102, the side faces of the first nitride semiconductor layer 104, as well as part of the front surfaces and the side faces of the second nitride semiconductor layers 106a, 106b that are uncovered through etching, are exposed to the etching gas plasma, and etching damage is formed thereon as a result. Herein, N desorbs at a region 103 at which etching damage is formed in the nitride semiconductor substrate 102. Also, N desorbs at a region 105 at which etching damage is formed in the first nitride semiconductor layer 104, so that there increases the concentration of n-type impurity at the region 105 where etching damage is formed. Likewise, N desorbs at a region 107 at which etching damage is formed in the second nitride semiconductor layers 106a, 106b, and the region 107 at which etching damage is formed is imparted with n-type conductivity. As a result, an n-type current path forms from the drain electrode 118, through the nitride semiconductor substrate 102 and the regions 105, 107 at which etching damage is formed, up to the source electrodes 112a, 112b. Accordingly, upon application of voltage across the drain electrode 118 and the source electrodes 112a, 112b, leakage current may occur between the drain electrode 118 and the source electrodes 112a, 112b, via that current path.

The present invention was created in the light of the above problems. It is an object of the present invention to provide a vertical nitride semiconductor device in which occurrence of a leakage current can be suppressed, and to provide a method for manufacturing such a nitride semiconductor device.

### SOLUTION TO TECHNICAL PROBLEM

The present invention relates to a nitride semiconductor device. The nitride semiconductor device of the present invention comprises a first nitride semiconductor layer, a second nitride semiconductor layer, a third nitride semiconductor layer, and a front surface electrode. The first nitride semiconductor layer is n-type. The second nitride semiconductor layer is formed on a part of a front surface of the first nitride semiconductor layer and p-type. The third nitride semiconductor layer is formed on the front surface of the first nitride semiconductor layer and a front surface of the second nitride semiconductor layer and n-type. The front surface electrode is formed on a part of the front surface of the second nitride semiconductor layer. An opening is formed in the third nitride semiconductor layer at a position isolated from a peripheral edge of the third nitride semiconductor layer, penetrating the third nitride semiconductor layer and reaching the front surface of the second nitride semiconductor layer. The front surface electrode is formed inside the opening. Furthermore, a back surface electrode is formed on a back surface of the nitride semiconductor device.

In the above nitride semiconductor device, an opening formed in the third nitride semiconductor layer is provided at a position isolated form a peripheral edge of the third nitride semiconductor layer. Upon formation of the opening in the third nitride semiconductor layer, therefore, an etching damage is formed, within the second nitride semiconductor layer, at a region corresponding to the position at which the opening is formed. However, no etching damage is formed at the region covered by the third nitride semiconductor layer. As a result, the etching damage formed in the second nitride semiconductor layer (the etching damage in contact with the front surface electrode) is surrounded by the region of the second nitride semiconductor layer at which no etching damage is formed. That is, the region at which the etching damage is formed is isolated, by the p-type second nitride semiconductor layer, from sites at which other etching damage is formed. As a result, current paths that extend from the back surface electrode, through regions at which the etching damage is formed, up to the front surface electrode, are rendered discontinuous, and the occurrence of the leakage current between the back surface electrode and the front surface electrode is suppressed.

In the nitride semiconductor device above mentioned, the nitride semiconductor device may further comprise a fourth nitride semiconductor layer of n-type in hetero junction with a front surface of third nitride semiconductor layer. In this case, a HEMT in which a channel is formed at a hetero junction surface between the third nitride semiconductor layer and the fourth nitride semiconductor layer can be realized.

In the nitride semiconductor device above mentioned, the front surface electrode may be isolated from the third nitride semiconductor layer formed between a termination portion of the nitride semiconductor device and the opening. In this case, the amount of material necessary for forming the front surface electrode during manufacture of the nitride semiconductor device can be reduced.

In the nitride semiconductor device above mentioned, the third nitride semiconductor layer may be formed to a termination portion of the nitride semiconductor device. In this case, the region at which the etching damage is formed during the manufacture of the nitride semiconductor device can be reduced. As a result, the occurrence of the leakage current between the back surface electrode and the front surface electrode can be effectively suppressed.

In the nitride semiconductor device above mentioned, a termination portion of the second nitride semiconductor layer may be exposed. The concentration of n-type impurity is higher and the leakage current likelier to occur in the first nitride semiconductor layer having the etching damage formed therein than in the second nitride semiconductor layer having the etching damage formed therein. In the above nitride semiconductor device, the side faces of the second nitride semiconductor layer on a termination portion side are not covered by the first nitride semiconductor layer, so that the region at which the etching damage is formed in the first nitride semiconductor layer can be reduced. As a result, the occurrence of the leakage current between the back surface electrode and the front surface electrode can be effectively suppressed.

In a nitride semiconductor device of another embodiment of the present invention, an etching damage is formed at a portion making contact with the front surface electrode within a region facing to the front surface of the second nitride semiconductor layer. The etching damage is surrounded by the second nitride semiconductor layer not having the etching damage. In this nitride semiconductor device, the etching damage directly below the region at which the opening is formed (the etching damage in contact with the front surface electrode) is discontinuous from the etching damage formed at other sites. As a result, the current paths that extend from the back surface electrode, through regions at which etching damage is formed, up to the front surface electrode, are rendered discontinuous, and the occurrence of the leakage current between the back surface electrode and the front surface electrode is suppressed. The etching damage can be detected by, for instance, TEM (Transmission Electron Microscope) after the manufacture of the nitride semiconductor device.

A method of manufacturing the nitride semiconductor device above mentioned comprises a third nitride semiconductor layer forming step, an opening forming step, and a front surface electrode forming step. The third nitride semiconductor layer forming step is a step for forming the third nitride semiconductor layer on the front surface of the second nitride semiconductor layer. The opening forming step is a step for forming the opening by etching a part of the third nitride semiconductor layer from a front surface of the third nitride semiconductor layer, penetrating the third nitride semiconductor layer and reaching the second nitride semiconductor layer. The front surface electrode forming step is a step for forming the front surface electrode on the front surface of the second nitride semiconductor layer exposed inside the opening after the opening forming step.

In the present method, during the formation of the opening in the opening forming step, the third nitride semiconductor layer remains on the second nitride semiconductor layer between the termination portion of the nitride semiconductor device and the opening. Therefore, no etching damage is formed at the region covered by the third nitride semiconductor layer, within the front surface of the second nitride semiconductor layer. As a result, the etching damage of the second nitride semiconductor layer formed directly below the opening is surrounded by the second nitride semiconductor layer at which no etching damage is formed. That is, the etching damage formed at the termination portion of the second nitride semiconductor layer is discontinuous from the etching damage of the second nitride semiconductor layer formed directly below the opening. The occurrence of the leakage current between the back surface electrode and the front surface electrode is suppressed accordingly in the nitride semiconductor device manufactured in accordance with the present method.

In the method above mentioned, the method may further comprise an ion doping step for doping ionized nitride, aluminum, carbon, or magnesium to a portion between a termination portion of the nitride semiconductor device and the opening before the opening forming step. Flow of the leakage current may occur even if the current paths that extend from the back surface electrode up to the front surface electrode, via the regions at which the etching damage is formed, are discontinuous. In the above method, the resistivity of the third nitride semiconductor layer is increased as a result of the ion implantation process. This allows suppressing flow of leakage current at a region, within the front surface of the second nitride semiconductor layer that is covered by the third nitride semiconductor layer. As a result, the occurrence of the leakage current between the back surface electrode and the front surface electrode can be effectively suppressed.

### ADVANTAGEOUS EFFECTS OF INVENTION

The present invention succeeds in providing a vertical nitride semiconductor device in which occurrence of a leakage current can be suppressed, and in providing a method for manufacturing such a nitride semiconductor device.

### BRIEF DESCRIPTION OF DRAWINGS

Fig.1 shows a cross sectional view of a nitride semiconductor device 100 of a first embodiment.
Fig.2 shows a cross sectional view of a step (1) of a manufacturing method of a nitride semiconductor device 100.
Fig.3 shows a cross sectional view of a step (2) of a manufacturing method of a nitride semiconductor device 100.
Fig.4 shows a cross sectional view of a step (3) of a manufacturing method of a nitride semiconductor device 100.
Fig.5 shows a cross sectional view of a step (4) of a manufacturing method of a nitride semiconductor device 100.
Fig.6 shows a cross sectional view of a step (5) of a manufacturing method of a nitride semiconductor device 100.
Fig.7 shows a cross sectional view of a step (6) of a manufacturing method of a nitride semiconductor device 100.
Fig.8 shows a cross sectional view of a step (7) of a manufacturing method of a nitride semiconductor device 100.
Fig.9 shows a cross sectional view of a step (8) of a manufacturing method of a nitride semiconductor device 100.
Fig.10 shows a cross sectional view of a nitride semiconductor device 200 of a second embodiment.
Fig.11 shows a cross sectional view of a nitride semiconductor device 300 of a third embodiment.
Fig.12 shows a cross sectional view of a nitride semiconductor device 400 of a fourth embodiment.
Fig.13 shows a cross sectional view of a nitride semiconductor device 500 of prior art.

### DETAILED DESCRIPTION OF THE PREFERRED EMBODIMENTS

Preferred aspects of below embodiments will be listed.
(Characterizing feature 1) The formula of a third nitride semiconductor layer is Al_{X}Ga_{Y}In_{1-X-Y}N (where 0≤X≤1, 0≤Y≤1, 0≤1-X-Y≤1). In this case, a hetero junction surface can be formed between the third nitride semiconductor layer and a fourth nitride semiconductor layer.
(Characterizing feature 2) A spacing of the region at which an etching damage is discontinuous is 1 µm or greater. In this case, flow of a leakage current at regions where the etching damage is discontinuous can be suppressed effectively.

### EMBODIMENT

Embodiments are explained next with reference to accompanying drawings.

### (First embodiment)

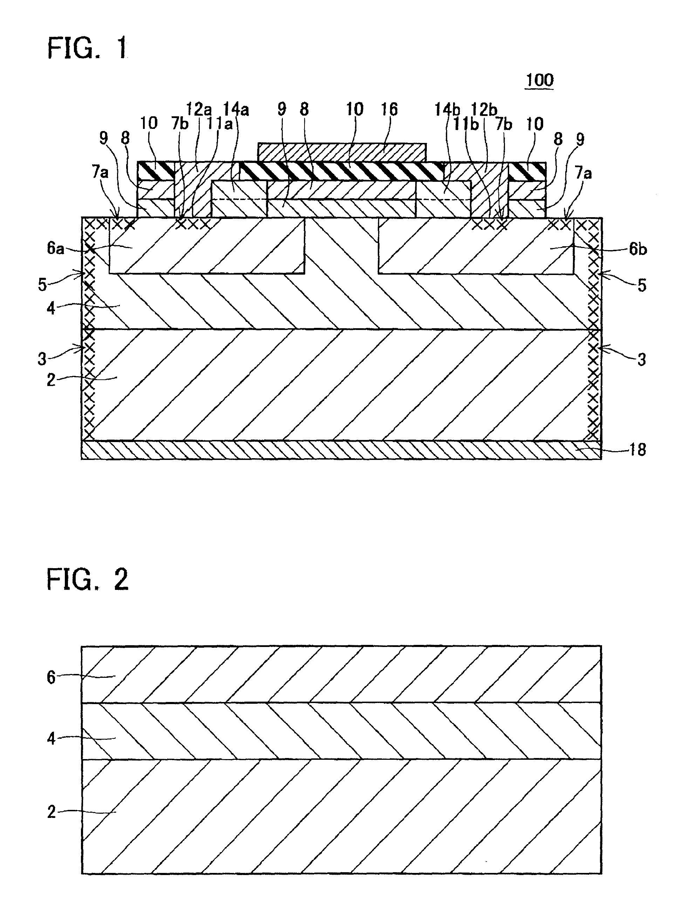

Fig. 1 is a cross-sectional diagram of part of a nitride semiconductor device 100 according to the first embodiment. The semiconductor device 100 is an n-channel type vertical semiconductor device having a HEMT structure. Specifically, a drain electrode (back surface electrode) 18 is formed on a back surface, and a pair of source electrodes (front surface electrodes) 12a, 12b is formed on the front surface, such that currents flow in the vertical direction. The nitride semiconductor device 100 comprises a nitride semiconductor substrate 2. The nitride semiconductor substrate 2 is formed of n⁺ type GaN. A first nitride semiconductor layer 4 is stacked on the front surface of the nitride semiconductor substrate 2. The first nitride semiconductor layer 4 is formed of n⁻ type GaN. A pair of second nitride semiconductor layers 6a, 6b is formed on the front surface of the first nitride semiconductor layer 4. The second nitride semiconductor layers 6a, 6b are formed of p⁺ type GaN. The first nitride semiconductor layer 4 is formed between the second nitride semiconductor layers 6a, 6b and also on the outer side faces of the second nitride semiconductor layers 6a, 6b. A third nitride semiconductor layer 9 is stacked on the front surface of the first nitride semiconductor layer 4 and on the front surfaces of the second nitride semiconductor layers 6a, 6b. The third nitride semiconductor layer 9 is formed of n- type GaN. The impurity concentration in the first nitride semiconductor layer 4 and the third nitride semiconductor layer 9 is identical. A fourth nitride semiconductor layer 8 is stacked on the front surface of the third nitride semiconductor layer 9. The fourth nitride semiconductor layer 8 is formed of n⁻ type AlGaN. The bandgap of the fourth nitride semiconductor layer 8 is greater than that of the third nitride semiconductor layer 9. The fourth nitride semiconductor layer 8 is in hetero junction with the third nitride semiconductor layer 9.

A pair of openings 11a, 11b is formed at parts of the fourth nitride semiconductor layer 8 and at parts of the third nitride semiconductor layer 9, from the front surface of the fourth nitride semiconductor layer 8 and penetrating the third nitride semiconductor layer 9, reaching the front surfaces of the second nitride semiconductor layers 6a, 6b. A pair of n⁺ type source regions 14a, 14b is provided at respective parts of the front surfaces of the second nitride semiconductor layers 6a, 6b. The source regions 14a, 14b are formed over the extent of the third nitride semiconductor layer 9 and the fourth nitride semiconductor layer 8, at positions facing the openings 11, such that hetero junction surfaces run across the interior of the source regions 14a, 14b. A pair of source electrodes 12a, 12b is provided in the respective openings 11a, 11b. The pair of source electrodes 12a, 12b is in contact with parts of the front surfaces of the second nitride semiconductor layers 6a, 6b and in contact with the source regions 14a, 14b. The source electrodes 12a, 12b are conductive with the third nitride semiconductor layer 9 and the fourth nitride semiconductor layer 8 via the source regions 14a, 14b. The front surface of the fourth nitride semiconductor layer 8 is covered by a gate insulating film 10. A gate electrode (control electrode) 16 is provided on an area intervened by the pair of source electrodes 12a, 12b, on the front surface of the gate insulating film 10. The termination portion of the nitride semiconductor device 100 is in contact, for instance, with an element isolating section (not shown). For instance, an element isolating trench (not shown) is provided at the element isolating section, such that the nitride semiconductor device 100 is electrically isolated from other nitride semiconductor devices.

The operation of the nitride semiconductor device 100 is explained next. The nitride semiconductor device 100 is used with a voltage being applied across the source electrodes 12a, 12b and the drain electrode 18. If no positive voltage is applied to the gate electrode 16, no 2DEG forms at the hetero junction surface of the third nitride semiconductor layer 9 and the fourth nitride semiconductor layer 8. As a result, the nitride semiconductor device 100 is kept in an off state. When the positive voltage is applied to the gate electrode 16, a 2DEG forms at that hetero junction surface between the third nitride semiconductor layer 9 and the fourth nitride semiconductor layer 8, at a position between the pair of source regions 14a, 14b. As a result, the nitride semiconductor device 100 is turned on. The nitride semiconductor device 100 causes electrons to move by way of the 2DEG. Electron mobility is high, which enables highspeed operation.

Next, a method for manufacturing the nitride semiconductor device 100 is explained. First, the n⁻ type first nitride semiconductor layer 4 is grown by MOCVD, using GaN as a material, on the front surface of the n⁺ type nitride semiconductor substrate 2 that has GaN as a material. The impurity concentration of the nitride semiconductor substrate 2 is 3×10¹⁸ cm⁻³. The introduced impurity is Si, and the thickness is 200 µm. The impurity concentration of the first nitride semiconductor layer 4 is 3×10¹⁶ cm⁻³, the introduced impurity is Si, and the grown thickness is 6 µm. Next, as shown in Fig. 2, a p⁺ type second nitride semiconductor layer 6, having GaN as a material, is formed by MOCVD on the front surface of the first nitride semiconductor layer 4. The impurity concentration of the second nitride semiconductor layer 6 is 1×10¹⁸cm⁻³, the introduced impurity is Mg, and the grown thickness is 0.5 µm.

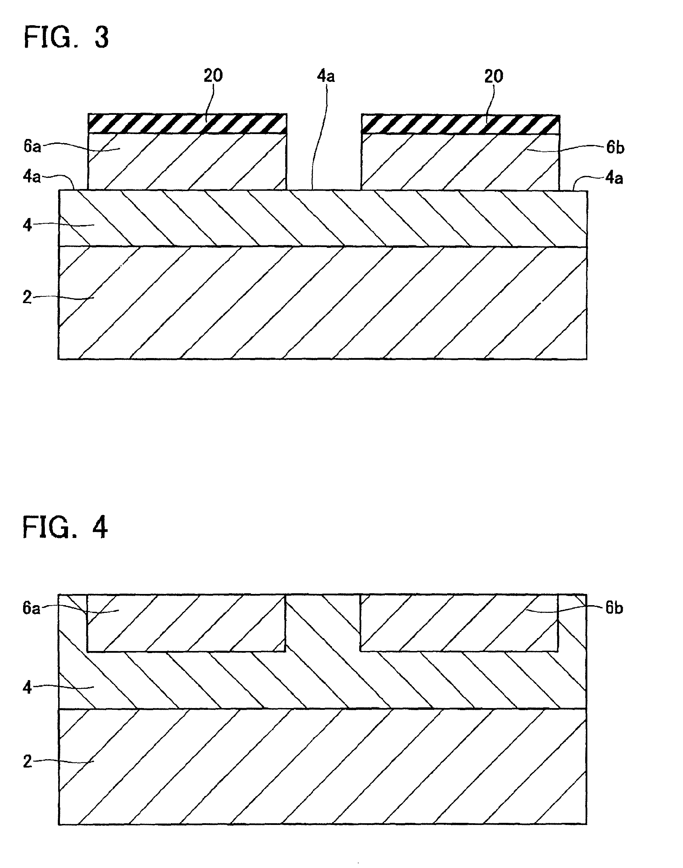

Next, as shown in Fig. 3, first silicon oxide films 20 are formed at parts of a front surface of the second nitride semiconductor layer 6. Next, dry etching is performed, using the first silicon oxide films 20 as the mask, from the front surface of the second nitride semiconductor layer 6 to a front surface of the second nitride semiconductor layer 4 (down to a depth of 0.5 µm). As a result, the second nitride semiconductor layer 6 is divided into the pair of second nitride semiconductor layers 6a, 6b. The dry etching method may be, for instance, RIE. Next, n⁻ type GaN is grown, by MOCVD, on a front surface 4a of the first nitride semiconductor layer 4 exposed by dry etching, to further form first nitride semiconductor layer 4. Herein, the first nitride semiconductor layer 4 is formed until the front surface of the first nitride semiconductor layer 4 stands leveled at the same height as the front surface of the second nitride semiconductor layers 6a, 6b. Specifically, a further 0.5 µm thickness of the first nitride semiconductor layer 4 is formed thereby. Next, as shown in Fig. 4, the first silicon oxide films 20 are removed, using an HF aqueous solution or the like.

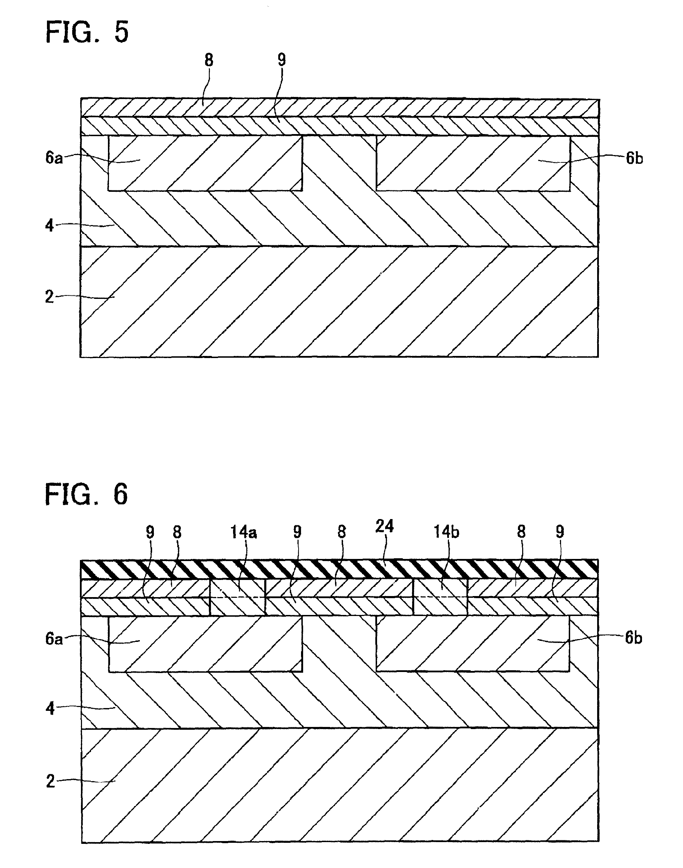

Next, 100 nm of the n⁻ type third nitride semiconductor layer 9 are formed, by MOCVD, on the front surfaces of the first nitride semiconductor layer 4 and the second nitride semiconductor layers 6a, 6b. The material and impurity concentration of the third nitride semiconductor layer 9 are identical to those of the first nitride semiconductor layer 4. Next, as shown in Fig. 5, the n⁻ type fourth nitride semiconductor layer 8 having Al_{0.3}Ga_{0.7}N as a material is formed by MOCVD on a front surface of the third nitride semiconductor layer 9. The impurity concentration in the fourth nitride semiconductor layer 8 is 1×10¹⁶cm⁻³, and the grown thickness is 25 nm. Next, a second silicon oxide film (not shown) is formed on a front surface of the fourth nitride semiconductor layer 8. Next, parts of the second silicon oxide film are removed to expose the fourth nitride semiconductor layer 8 at areas where the source regions 14a, 14b are to be formed. Next, N and Si are sequentially implanted, using an ion implantation apparatus, into front surfaces of the exposed fourth nitride semiconductor layer 8. The implantation amount on N is 1×10¹⁶ cm⁻³, the acceleration voltage during implantation is 35 keV. The implantation amount on Si is 1×10¹⁵ cm⁻³, the acceleration voltage during implantation is 65 keV. Next, as shown in Fig. 6, the second silicon oxide film is removed, a third silicon oxide film 24 is formed thereafter on the entire front surface, and annealing is performed. The annealing temperature is 1300°C and the annealing time is 5 minutes. The n⁺ type source regions 14a, 14b become formed as a result at the N and Si implanted regions.

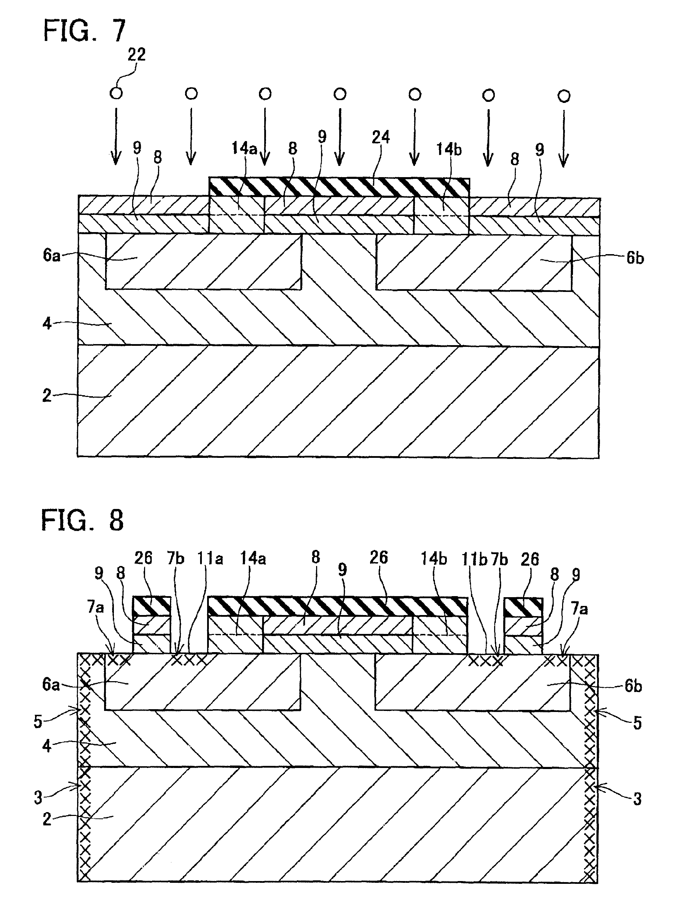

Next the third silicon oxide film 24 covering the fourth nitride semiconductor layer 8 on an outside of the source regions 14a, 14b is removed. Next, as shown in Fig. 7, Al ions 22 are implanted through the front surface of the fourth nitride semiconductor layer 8. As a result of this implantation, the Al ions 22 reach down to the third nitride semiconductor layer 9, penetrating the fourth nitride semiconductor layer 8, at the portion not covered by the third silicon oxide film 24. The resistivity of those portions within the third nitride semiconductor layer 9 that are implanted with Al ions, rises as a result. Next, the third silicon oxide film 24 is removed, and a fourth silicon oxide film 26 is formed on an entirety of the front surface. Next, parts of the fourth silicon oxide film 26 are removed, to expose the fourth nitride semiconductor layer 8 at the areas where the openings 11a, 11b are to be formed, and to expose the fourth nitride semiconductor layer 8 that covers the termination portion. Next, as shown in Fig. 8, dry etching is performed, from a front surface of the exposed fourth nitride semiconductor layer 8, penetrating the third nitride semiconductor layer 9, and reaching the second nitride semiconductor layers 6a, 6b. Etching damage occurs at this time at the exposed portions of the nitride semiconductor substrate 2, the first nitride semiconductor layer 4 and the second nitride semiconductor layers 6a, 6b.

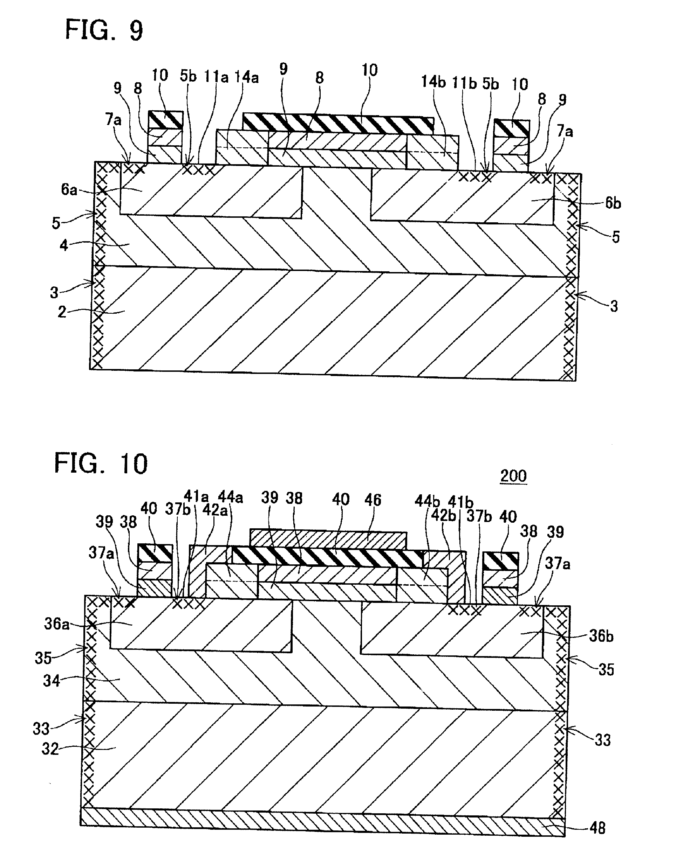

Next, the fourth silicon oxide film 26 is removed. Next, 50 nm of the gate insulating film 10 is formed by performing HTO (High-Temperature-Oxide)-CVD on the front surfaces of the fourth nitride semiconductor layer 8 and the source regions 14a, 14b. Next, as shown in Fig. 9, parts of the gate insulating film 10 formed on the front surfaces of the source regions 14a, 14b are removed by etching. Next, the pair of source electrodes 12a, 12b is formed through vapor deposition, of Ti/Al films to a thickness of 10 nm/100 nm, respectively, at the front surface of the second nitride semiconductor layers 6a, 6b exposed within the openings 11a, 11b, and the front surfaces of the source regions 14a, 14b. Simultaneously therewith, the drain electrode 18 is formed through vapor deposition of a Ti/Al film, to a thickness of 10 nm/100 nm, respectively, on the back surface of the nitride semiconductor substrate 2. A gate electrode 16 having Ni as a material is formed at a front surface of the gate insulating film 10, at an area positioned between the pair of source electrodes 12a, 12b above the fourth nitride semiconductor layer 8. As a result, the nitride semiconductor device 100 (Fig. 1) is completed.

In the method for manufacturing the nitride semiconductor device 100, the etching damage 3 is formed at the termination portion of the nitride semiconductor substrate 2. In the part of the first nitride semiconductor layer 4 at the termination portion of the nitride semiconductor device 100, an etching damage 5 whose n-type impurity concentration is higher than that at other portions of the first nitride semiconductor layer 4 is formed. Etching damages 7a, 7b are formed at areas within the front surface of the second nitride semiconductor layers 6a, 6b that are not in contact with the third nitride semiconductor layer 9. The etching damages 7a, 7b are imparted with n-type conductivity. As a result, the etching damages 7b formed directly below the front surface electrodes 12a, 12b are surrounded by the second nitride semiconductor layers 6a, 6b in which no etching damage is formed. That is, the etching damage 5 and the etching damages 7b are discontinuous. In the nitride semiconductor device 100, as a result, the current paths between the drain electrode 18 and the source electrodes 12a, 12b are discontinuous. The occurrence of the leakage current between the drain electrode 18 and the source electrodes 12a, 12b is thus suppressed. The spacing of the region at which etching damage is discontinuous (spacing between the etching damage 7a and the etching damage 7b) is 1 µm or greater. As a result, this allows effectively suppressing the flow of the leakage current at regions where the etching damage is discontinuous.

### (Second embodiment)

Fig. 10 is a cross-sectional diagram of a nitride semiconductor device 200 according to a second embodiment. In Fig. 10, those members resulting from adding 30 to the reference numerals of Fig. 1 are identical to the members explained in Fig. 1. In the nitride semiconductor device 200. source electrodes 42a. 42b are isolated from a third nitride semiconductor layer 39 and a fourth nitride semiconductor layer 38, on the termination portion side. In the nitride semiconductor device 200, as a result, the amount of metal material required for forming the source electrodes 42a, 42b is smaller than that in the nitride semiconductor device 100 of the first embodiment.

### (Third embodiment)

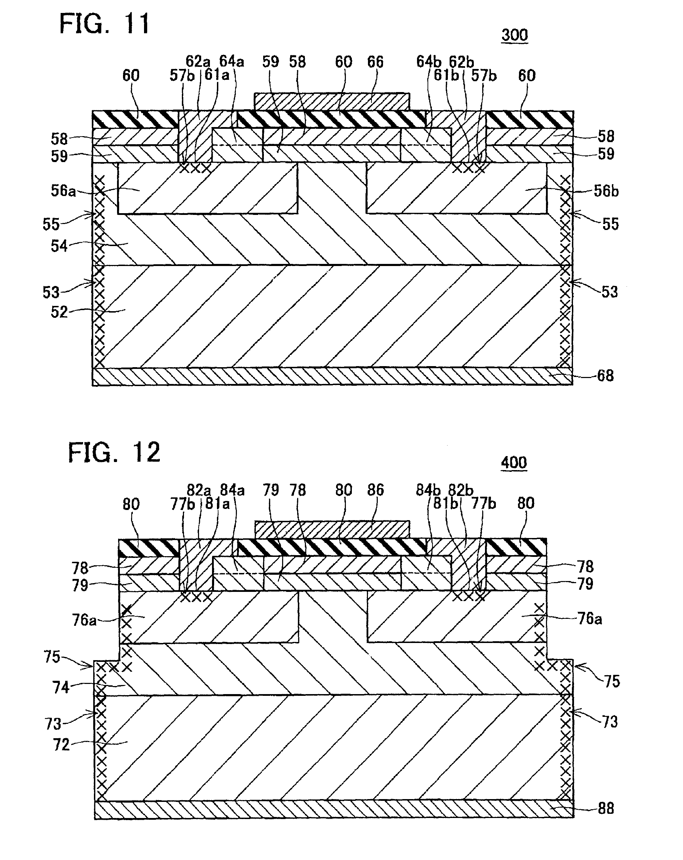

Fig. 11 is a cross-sectional diagram of a nitride semiconductor device 300 according to a third embodiment. In Fig. 11, those members resulting from adding 50 to the reference numerals of Fig. 1 are identical to the members explained in Fig. 1. In the nitride semiconductor device 300, a third nitride semiconductor layer 59 is provided continuously to the termination portion of the nitride semiconductor device 300. That is, the third nitride semiconductor layer 59 is provided on entire front surfaces of second nitride semiconductor layers 56a, 56b, except at openings 61 a, 6 1b.

In the process of forming the openings 61a, 61b (process corresponding to Fig. 8 of the first embodiment) during the method for manufacturing the nitride semiconductor device 300, etching is performed only at the areas where the openings 61 a, 61 b are to be formed. As a result, etching damage is formed only at the termination portion of the nitride semiconductor substrate 52, the termination portion of the first nitride semiconductor layer 54, and the front surfaces of the second nitride semiconductor layers 56a, 56b at the areas where the openings 61a, 61b are formed. Therefore, etching damages 57b and etching damage 55 are discontinuous. In the nitride semiconductor device 300, no etching damage is formed at the front surfaces of the second nitride semiconductor layers 56a, 56b other than at surface-exposed regions on account of the openings 61a, 61b. Therefore, the regions at which etching damages are formed is smaller than in the nitride semiconductor device 100 of the first embodiment. The occurrence of leakage current between a drain electrode 68 and source electrodes 62a, 62b is thus effectively suppressed.

### (Fourth embodiment)

Fig. 12 is a cross-sectional diagram of a nitride semiconductor device 400 according to a fourth embodiment. In Fig. 11 those members resulting from adding 70 to the reference numerals of Fig. 1 are identical to the members explained in Fig. 1. The nitride semiconductor device 400 has the structure of the nitride semiconductor device 300 of the third embodiment but herein the first nitride semiconductor layer 54 that covers the side faces of the second nitride semiconductor layers 56a, 56b, on the termination portion side, is etched to a deeper depth than the back surface of the second nitride semiconductor layers 56a, 56b. In the nitride semiconductor device 400, thus, the side faces of second nitride semiconductor layers 76a, 76b are exposed. Therefore, the region at which etching damage is formed in the first nitride semiconductor layer 74 is reduced. Herein, etching damage 75 that forms in the first nitride semiconductor layer 74 is n⁺ type, and etching damage 77b that is formed in the second nitride semiconductor layers 76a, 76b is n⁻ type. Therefore, the etching damage 75 that is formed in the first nitride semiconductor layer 74 has lower carrier resistance than the etching damages 77b that are formed in the second nitride semiconductor layers 76a, 76b. That is, the leakage current flows more readily in the etching damage 75 than in the etching damages 77b. In the nitride semiconductor device 400, the leakage current that occurs between a drain electrode 88 and source electrodes 82a, 82b is suppressed through reduction of the etching damage 75 that is formed in the first nitride semiconductor layer 74.

Specific embodiment of the present invention is described above, but this merely illustrates some representative possibilities for utilizing the invention and does not restrict the claims thereof. The subject matter set forth in the claims includes variations and modifications of the specific examples set forth above. The technical elements disclosed in the specification or the drawings may be utilized separately or in all types of combinations, and are not limited to the combinations set forth in the claims at the time of filing of the application. Furthermore, the subject matter disclosed herein may be utilized to simultaneously achieve a plurality of objects or to only achieve one object.

### REFERENCE SIGNS LIST

2, 32, 52, 72, 102: nitride semiconductor substrate
3, 33, 53, 73: etching damage (formed in a nitride semiconductor substrate)
4, 34, 54, 74, 104: first nitride semiconductor layer
5, 35, 55, 75: etching damage (formed in a first semiconductor layer)
6a, 6b, 36a, 36b, 56a, 56b, 76a, 76b, 106a, 106b: second nitride semiconductor layer
7a, 7b, 37a, 37b, 57a, 57b, 77a, 77b: etching damage (formed in a second semiconductor layer)
8, 38, 58, 78, 108: fourth nitride semiconductor layer
9, 39, 59, 79, 109: third nitride semiconductor layer
10,40, 60, 80, 110: gate insulator film
11a, 11b, 41a, 41b, 61a, 61 b, 81a, 81b: opening
12a, 12b, 42a, 42b, 62a, 62b, 82a, 82b, 112a, 112b: source electrode
14a, 14b, 44a, 44b, 64a, 64b, 84a, 84b, 114a, 114b: source region
16, 46, 66, 86, 116: gate electrode
18, 48, 68, 88, 118: drain electrode
22: Aluminum ion
24: third silicon oxide film
26: fourth silicon oxide film
100, 200, 300, 400, 500: nitride semiconductor device
103, 105, 107: etching damaged region

## Claims

1. A nitride semiconductor device, comprising:
a first nitride semiconductor layer of n-type;
a second nitride semiconductor layer of p-type formed on a part of a front surface of the first nitride semiconductor layer;
a third nitride semiconductor layer of n-type formed on the front surface of the first nitride semiconductor layer and a front surface of the second nitride semiconductor layer; and
a front surface electrode formed on a part of the front surface of the second nitride semiconductor layer;
wherein an opening is formed in the third nitride semiconductor layer at a position isolated from a peripheral edge of the third nitride semiconductor layer, penetrating the third nitride semiconductor layer and reaching the front surface of the second nitride semiconductor layer, and
the front surface electrode is formed inside the opening.

2. The nitride semiconductor device as in claim 1, further comprising:
a fourth nitride semiconductor layer of n-type in hetero junction with a front surface of the third nitride semiconductor layer.

3. The nitride semiconductor device as in claim 1 or 2, wherein
the front surface electrode is isolated from the third nitride semiconductor layer formed between a termination portion of the nitride semiconductor device and the opening.

4. The nitride semiconductor device as in any one of claims 1 to 3, wherein
the third nitride semiconductor layer is formed to a termination portion of the nitride semiconductor device.

5. The nitride semiconductor device as in any one of claims 1 to 4. wherein
a termination portion of the second nitride semiconductor layer is exposed.

6. A nitride semiconductor device, comprising:
a first nitride semiconductor layer of n-type;
a second nitride semiconductor layer of p-type formed on a part of a front surface of the first nitride semiconductor layer;
a third nitride semiconductor layer of n-type formed on the front surface of the first nitride semiconductor layer and a front surface of the second nitride semiconductor layer; and
a front surface electrode formed on a part of the front surface of the second nitride semiconductor layer;
wherein an etching damage is formed at a portion making contact with the front surface electrode within a region facing the front surface of the second nitride semiconductor layer, and
the etching damage is surrounded by the second nitride semiconductor layer not having the etching damage.

7. A method of manufacturing the nitride semiconductor device as in any one of claims 1 to 6, comprising:
a third nitride semiconductor layer forming step for forming the third nitride semiconductor layer on the front surface of the second nitride semiconductor layer;
an opening forming step for forming the opening by etching a part of the third nitride semiconductor layer from a front surface of the third nitride semiconductor layer, penetrating the third nitride semiconductor layer and reaching the second nitride semiconductor layer, and
a front surface electrode forming step for forming the front surface electrode on the front surface of the second nitride semiconductor layer exposed inside the opening.

8. The method of claim 7, further comprising:
an ion doping step for doping ionized nitride, aluminum, carbon, or magnesium to a portion of the third nitride semiconductor layer between a termination portion of the nitride semiconductor device and the opening.
